# EUROPÄISCHE PATENTSCHRIFT

(11) **EP 2 035 900 B1**
(45) Veröffentlichungstag und Bekanntmachung des Hinweises auf die Patenterteilung: **01.12.2010**
(21) Anmeldenummer: 07730168.7
(22) Anmeldetag: 14.06.2007
(51) Int. Cl.: G05B 19/042, G01R 27/14

(54) **VERFAHREN ZUR BESTIMMUNG DES BÜRDENWIDERSTANDES FÜR EINEN MESSUMFORMER**
METHOD FOR DETERMINING THE LOAD IMPEDANCE OF A MEASURING TRANSDUCER
PROCÉDÉ DE DÉTERMINATION DE LA RÉSISTANCE DE CHARGE D'UN CONVERTISSEUR DE MESURE

(30) Priorität: 30.06.2006 DE 102006030774
(43) Veröffentlichungstag der Anmeldung: 18.03.2009
(73) Patentinhaber: Endress+Hauser Conducta Gesellschaft für Mess- und Regeltechnik mbH+Co. KG, 70839 Gerlingen (DE)
(72) Erfinder: GEHRKE, Martin, 71384 Weinstadt (DE); KNOPP, Matthias, 71287 Weissach-Flacht (DE)
(74) Vertreter: Andres, Angelika Maria
(86) Internationale Anmeldenummer: PCT/EP2007/055909
(87) Internationale Veröffentlichungsnummer: WO 2008/000631

(56) Entgegenhaltungen:
- WO-A-95/08123
- WO-A-2005/121816
- DE-A1- 10 220 390
- DE-A1- 19 905 071
- DE-C1- 19 641 648
- US-A- 4 206 648

## Beschreibung

Die Erfindung betrifft ein Verfahren zur Bestimmung des Bürdenwiderstandes für einen Messumformer gemäß dem Oberbegriff des Anspruchs 1.

In der Prozessautomatisierungstechnik werden vielfach Messumformer eingesetzt, die Messwerte analog als 4-20 mA Signal an Prozessleitsysteme übertragen. Im Prozessleitsystem wird der Spannungsabfall, den das 4-20 mA Signal an einem Bürdenwiderstand verursacht, ausgewertet. Entsprechend der im Messumformer zur Verfügung stehenden Versorgungsspannung darf der Bürdenwiderstand einen bestimmten Maximalwert nicht überschreiten, um den vollen Messbereich vom Messumformer an das Leitsystem übertragen zu können.

Ein zu groß ausgelegter Bürdenwiderstand sollte bereits bei der Inbetriebnahme eines Messumformers erkannt werden. Andernfalls können gewisse Messwerte möglicher Weise nur noch verfälscht ans Leitsystemen übertragen werden.

Mit heutigen bekannten Verfahren zur Überwachung für einen Bürdenwiderstandes, häufig einfach als Bürdenüberwachung bezeichnet, können neben zu groß ausgelegten Bürdenwiderständen auch Leitungsbrüche in den Verbindungsleitungen für das 4-20 mA Signal erkannt werden. Hierfür sind verschiedene Methoden bekannt, vor denen zwei nachfolgend erläutert sind.

Bei einer ersten Methode wird der Stromregler, mit das 4-20 mA Signal eingestellt wird, überwacht. Ist der Bürdenwiderstand zu hoch, kann die Regelabweichung nicht mehr vom Regler ausgeglichen werden. Bleibt die Regelabweichung über einen längeren Zeitraum in einer bestimmten Höhe bestehen, so ist dies ein sicheres Indiz dafür, dass der Bürdenwiderstand einen zu großen Wert aufweist. Trifft diese Regelabweichung nur bei extremen Messwerten auf, so ist bei der Inbetriebnahme des Messumformers nicht gewährleistet, dass der zu große Bürdenwiderstand sofort erkannt wird. Es kann nicht ausgeschlossen werden, dass ein solcher extremer Messwert erst mit einer erheblichen zeitlichen Verzögerung auftritt. Damit kann der Fehler nicht bei der Inbetriebnahme sondern erst mit einer erheblichen zeitlichen Verzögerung erkannt werden.

Eine weitere Methode zur Bürdenüberwachung besteht darin, die speisende Spannung zu überwachen, die aufgrund des Innenwiderstandes der verwendeten Spannungsquelle beim Anschluss eines Bürdenwiderstandes abnehmen muss. Liegt die Spannung bei angeschlossenem Bürdenwiderstand zu hoch, so ist dies ein Indiz für einen falschen Bürdenwiderstand oder unter Umständen sogar für einen Leitungsbruch. In Dokument DE 19905071 A1 ist ein Verfahren zur Diagnose der Versorgung eines Messumformers beschrieben, der zur Versorgung mit der zum Betrieb erforderlichen Energie und zur Übertragung eines eine Messgröße darstellenden Stromsignals an eine Zweidrahtleitung anschließbar ist. Hierzu wird zu einem ersten Zeitpunkt, wie z.B. bei Inbetriebnahme des Messumformers, nacheinander ein erster Wert und ein zweiter Wert des Stromsignals, z.B. 4 mA und 20 mA, eingestellt und die zugehörigen Werte der elektrischen Spannung an den Anschussklemmen, die für die Zweidrahtleitung zur Versorgung des Messumformers vorgesehen sind, erfasst und abgespeichert. Ein erster Wert des ohmschen Widerstands in den Versorgungsleitungen wird anhand der Verhältnisse von den Differenzen der Spannungswerte zu den Differenzen der Stromwerte, die zum ersten Zeitpunkt abgespeichert wurden, ermittelt. Zu einem zweiten, vom ersten abweichenden Zeitpunkt, wird bei einem im Prinzip beliebigen dritten Wert des Stromsignals der zugehörig Wert der elektrischen Spannung an den Anschlussklemmen erfasst und anhand der zuvor ermittelten Strom- bzw. Spannungswerte ein zweiter Wert des ohmschen Widerstandes ermittelt. Aus der Differenz dieses zweiten Widerstandswertes und dem aus den zum ersten Zeitpunkt ermittelten Strom-/Spannungswerten abgeleiteten ersten Widerstandswert wird als Maß für die Versorgungsqualität herangezogen. Ein Verfahren zur Widerstandsmessung ist aus DE 1964164 C1 bekannt. Dabei wird ein unbekannter Widerstand bestimmt indem zunächst ein Kondensator über einen bekannten Referenzwiderstand aufgeladen und ausschließlich 'über den Referenzwiderstand nach Masse wieder entladen wird, wobei die Zeit vom Beginn der Entladung bis zu dem Zeitpunkt gemessen wird, in dem die Kondensatorspannung auf einen vorbestimmten Referenzspannungswert abgesunken ist. Anschließend wird der Kondensator erneut über den Referenzwiderstand aufgeladen und danach über den Messwiderstand nach Masse entladen. Die Zeit zwischen dem Beginn der Entladung und dem Zeitpunkt, in dem die Kondensatorspannung den vorgegebenen Referenzspannungswert unterschreitet, wird wiederum gemessen. Aus den so ermittelten Entladezeiten und dem bekannten Referenzwiderstandwert kann der unbekannte Widerstandswert des Messwiderstandes ermittelt werden.

Eine weitere Methode der Bürdenüberwachung besteht darin, die Versorgungsspannung und den aktuellen fließenden Strom zu digitalisieren und daraus gemäß dem Ohmschen Gesetz den aktuellen Bürdenwiderstand zu berechnen.

Die beiden ersten Methoden sind einfach zu implementieren, sie besitzen jedoch den Dachteil, das ein falscher d. h. ein zu großer Bürdenwiderstand erst mit erheblicher zeitlicher Verzögerung erkannt wird.

Präventivmaßnahmen sind bei den ersten beiden Methoden nicht möglich.

Die letzte Methode gibt eine weitgehende Information über den Zustand der Stromschleife insbesondere über den exakten Wert des Bürdenwiderstandes. Sie ermöglicht damit eine Risikobewertung der Stromschleife und damit des gesamten Messsystems. Sie ist jedoch mit erheblichem elektronischem Aufwand im Messumformer verbunden, insbesondere wenn eine galvanische Trennung im Messumformer zwischen der eigentlichen Auawerteschaltung und Stromschleife erforderlich ist.

Mit der letzten Methode kann aber sichergestellt werden, dass ein zu hoher Bürdenwiderstand bereits bei der Inbetriebnahme des Messurnformers erkannt wird.

Aufgabe der Erfindung ist es deshalb ein Verfahren zur Bestimmung des Bürdenwiderstandes für einen Messumformer anzugeben, das die oben genannten Nachteile nicht aufweist, dass insbesondere einfach und kostengünstig realisierbar ist.

Gelöst wird diese Aufgabe durch die im Anspruch 1 angegebenen Verfahrensmerkmale.

Vorteilhafte Weiterentwicklungen der Erfindung sind in den Unteransprüchen angegeben.

Die wesentliche Idee der Erfindung besteht darin, ein Test-Spannungssignal kapazitiv auf die Stromschleife einzukoppeln und das entsprechende Stromsignal auszuwerten und den Widerstandswert des Büfdenwiderstandes aus einem chaxaktexistischen. Merkmal des Stromsignales zu bestimmten.

Nachfolgend ist die Erfindung anhand eines in der Zeichnung dargestellten Ausführungsbeispiels näher erläutert.

Es zeigt:

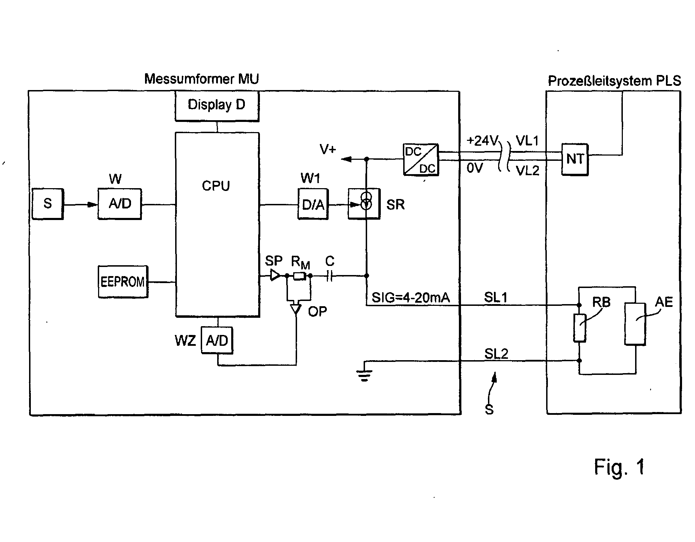

Fig. 1 Vier-Draht-Messumformer mit prozessleitsystem

in schematischer Darstellung.

In Fig. 1 ist ein Messumformer MU und ein Prozessleitsystem PLS, die in Vier-Draht-Technik über zwei Leitungspaare miteinander verbunden sind, schematisch dargestellt. Der Messumformer MU weist einen Messaufnehmer S zur Erfassung eines Messwertes (z. B. Temperatur, Druck, pH Wert etc.) auf. Das Ausgangssignal des Messaufnehmers S wird in einem Analog-Digitalwandler W digitalisiert und an einen Mikroprozessor CPU, in dem das Messsignal aufbereitet wird, weitergeleitet. Das aufbereitete Messsignal wird über eine 4-20 mA Stromschleife S an das Prozessleitsystem PLS übertragen. Hierzu steuert der Mikroprozessor CPU über einen Digital-Analogwandler W1 einen Stromregler SR entsprechend an. Über den vorgegebenen aufbereiteten Messwert wird das 4-20 mA Signal SIG eingestellt. Die Stromschleife S besteht im Wesentlichen aus zwei Signalleitungen SL1 und SL2 (zweites Leitungspaar), die mit einem Bürdenwiderstand R_{B} im Prozessleitsystem verbunden sind. Über den Bürdenwiderstand R_{B} wird das 4-20 mA Signal SIG im Prozessleitsystem PLS abgegriffen und in einer Auswerteeinheit E entsprechend ausgewertet um z. B. entsprechende Steuervorgänge auszulösen.

Meist sind Prozessleitsysteme noch mit weiteren Sensoren und gegebenenfalls auch mit Aktoren (z. B. Ventile) verbunden.

Die Spannungsversorgung des Messumformers erfolgt über zwei separate Versorgungsleitungen VL1 und VL2 (erstes Leitungspaar), die mit einem Netzteil NT im Prozessleitsystem PLS verbunden sind. Diese beiden Leitungen führen zu einem DC-DC Wandler, der eine Versorgungsspannung V+ zur Versorgung der verschiedenen elektrischen Komponenten um Messumformer MU liefert.

Zur Darstellung insbesondere des aktuellen Messwerts vor Ort am Messumformer MU dient ein Display D, das ebenfalls mit dem Mikroprozessor CPU verbunden ist.

Erfindungsgemäß wird ein Test-Spannungssignal auf die Signalleitung SL eingekoppelt. Hierzu ist ein Signalausgang des Mikroprozessors CPU mit einem als Signalpuffer dienenden Operationsverstärker SP, einem Messwiderstand R_{M} und einem Kondensator C mit der Signalleitung SL1 verbunden. Der Spannungsabfall am Messwiderstand R_{M} wird über ein Operationsverstärker OP erfasst und über einen Analog-Digitalwandler W2 in digitaler Form an den Mikroprozessor CPU weitergeleitet.

Nachfolgend ist das erfindungsgemäße Verfahren näher erläutert.

In einem Verfahrensschritt a) wird ein Test-Spannungssignal im Messumformer MU erzeugt und über den Kondensator C auf die Stromschleife S eingekoppelt. Am Messwiderstand R_{M} wird das zum Test-Spannungssignal gehörende Stromsignal erfasst (Veifahrensschritt b) und an den Mikroprozessor CPU weitergeleitet. Im Mikroprozessor CPU erfolgt gemäß Verfahrensschritt c) die Auswertung des Stromsignals. Entsprechend dem bekannten exponentiellen Verhalten bei einer Kondensatoraufladung/-entladung kann im Mikroprozessor CPU aus einem charakteristischen Merkmal des Stromsignals z. B. über die Zeitkonstante RC der Widerstandswert des Bürdenwiderstands R_{B} ermittelt werden (Verfahrensschritt d).

In vorteilhafter Weise handelt es sich bei dem Test-Spannungssignal um ein Rechtecksignal.

In einer einfachen Kurvenauswertung ist es möglich die RC-Zeitkonstante über zwei Werte des Stromsignals bei unterschiedlichen Zeitpunkten t1 und t2 zu bestimmen.

Die Erzeugung und die Auswertung des Testsignals erfolgt mit Hilfe des im Messumformer MU vorgesehenen Mikroprozessor CPU.

Wird ein zu hoher Bürdenwiderstand festgestellt, so kann im Messumformer MU ein Fehlersignal generiert werde, das dem Anwender den Fehler (zu hoher Bürdenwiderstand) entsprechend anzeigt.

Mit Hilfe des erfindungsgemäßen Verfahrens kann in einfacher Weise ein zu hoher Bürdenwiderstand bereits bei der Inbetriebnahme des Messumformers erkannt werden. Ist der Bürdenwiderstand tatsächlich zu hoch, so kann der Messumformer ein entsprechendes Alarmsignal generierten und der Fehler schon bei der Inbetriebnahme behoben werden. Damit ist eine sicher Messwertübertragung zum Prozessleitsystem PLS über den gesamten Messbereich 4-20 mA gewährleistet.

Durch die kapazitive Einkopplung der Test-Spannungeignet sich die Erfindung besonders bei Messumformern mit galvanischer Trennung.

## Patentansprüche

1. Verfahren zur Bestimmung des Bürdenwiderstandes (RB) für einen Messumformer (MU), wobei der Messumformer (MU) über ein erstes Leitungspaar (VL1, VL2) mit Spannung versorgt wird und über ein zweites Leitungspaar (SL1, SL2) einer Stromschleife (S) ein variables Messsignal an ein Leitsystem (PLS) überträgt, wobei das Messsignal vom Messumformer (MU) geregelt und im Prozessleitsystem (PLS) an dem Bürdenwiderstand (RB) abgegriffen wird, **gekennzeichnet durch** folgende Verfahrensschritte
- Erzeugung eines Test-Spannungssignals im Messumformer (MU), das über einen Kondensator (C) auf die Stromschleife (S) eingekoppelt wird, wobei das Test Spannungssignal ein Rechtecksignal ist,
- Erfassen des zum Test-Spannungssignal gehörenden Stromsignals
- Auswerten des Stromsignals im Messumformer (MU)
- Bestimmung des Widerstandswertes des Bürdenwiderstandes (RB) aus einem charakteristischen Merkmal des Stromsignals, wobei als charakteristisches Merkmal des Stromsignals eine RC-Zeitkonstante dient, und wobei die RC-Zeitkonstante über die Messung von zwei Werten (Y1, Y2) des Stromsignals bei verschiedenen Zeitpunkten (t1, t2) bestimmt wird.

2. Verfahren nach einem der vorhergehenden Ansprüche, **dadurch gekennzeichnet, dass** die Erzeugung des Test-Spannungssignals und die Auswertung des Stromsignals in einem im Messumformer (MU) vorgesehenen Mikroprozessors (CPU) erfolgt.

3. Verfahren nach einem der vorhergehenden Ansprüche, **dadurch gekennzeichnet, dass** wenn der Widerstandswert des Bürdenwiderstands (RB) einen Grenzwert übersteigt ein Fehlersignal generiert wird.

## Claims

1. Method for determining the load resistor (RB) for a transmitter (MU), where the transmitter (MU) is supplied with voltage via a first pair of cables (VL1, VL2) and transmits a variable measuring signal to a control system (PCS) via a second pair of cables (SL1, SL2) of a current loop (S), where the measuring signal is regulated by the transmitter (MU) and measured in the process control system (PCS) at the load resistor (RB), **characterized by** the following process steps:
- Generation of a test voltage signal in the transmitter (MU) which is coupled onto the current loop (S) via a capacitor, whereby the test voltage signal is a square wave signal
- Recording of the current signal pertaining to the test voltage signal
- Evaluation of the current signal in the transmitter (MU)
- Determination of the resistance value of the load resistor (RB) from a characteristic feature of the current signal, where an RC time constant serves as a characteristic feature of the current signal and where the RC time constant is determined by measuring two values (Y1, Y2) of the current signal at different times (t1, t2).

2. Method as per one of the previous claims, **characterized in that** the test voltage signal is generated and the current signal is analyzed in a microprocessor (CPU) provided in the transmitter (MU).

3. Method as per one of the previous claims, **characterized in that** an error signal is generated if the resistance value of the load resistor (RB) exceeds a limit value.

## Revendications

1. Procédé destiné à la détermination de la résistance de charge (RB) pour un transmetteur (MU), le transmetteur (MU) étant alimenté en tension par l'intermédiaire d'une première paire de conducteurs (VL1, VL2) et transmettant un signal de mesure variable à un système numérique de contrôle commande (PLS) par l'intermédiaire d'une deuxième paire de conducteurs (SL1, SL2) d'une boucle de courant (S), le signal de mesure du transmetteur (MU) étant régulé et prélevé dans le système numérique de contrôle commande (PLS) au niveau de la résistance de charge (RB), **caractérisé par** les étapes de procédé suivantes :
- Génération d'un signal de tension de test dans le transmetteur (MU), qui est injecté à travers un condensateur (C) dans la boucle de courant (S), le signal de tension de test étant un signal rectangulaire,
- Acquisition du signal de courant appartenant au signal de tension de test
- Interprétation du signal de courant dans le transmetteur (MU)
- Détermination de la valeur de la résistance de charge (RB) à partir d'un critère caractéristique du signal de courant, une constante de temps RC servant de critère caractéristique du signal de courant et la constante de temps RC étant déterminée à travers la mesure de deux valeurs (Y1, Y2) du signal de courant pour différents instants (t1, t2).

2. Procédé selon la revendication 1, **caractérisé en ce que** la génération du signal de tension de test et l'interprétation du signal de courant s'effectuent dans un microprocesseur (CPU) prévu dans le transmetteur (MU).

3. Procédé selon la revendication 1, **caractérisé en ce que**, lorsque la valeur de la résistance de charge (RB) dépasse un seuil donné, un signal d'erreur est généré.
